(19) Europäisches Patentamt
European Patent Office
Office européen des brevets

(11) **EP 2 313 287 B1**

(12) **EUROPÄISCHE PATENTSCHRIFT**

(45) Veröffentlichungstag und Bekanntmachung des Hinweises auf die Patenterteilung:
**08.02.2012 Patentblatt 2012/06**

(21) Anmeldenummer: **09781305.9**

(22) Anmeldetag: **30.07.2009**

(51) Int Cl.:
*B60L 11/18* (2006.01)　　*H01M 10/48* (2006.01)
*H02J 7/00* (2006.01)　　*G01R 31/36* (2006.01)

(86) Internationale Anmeldenummer:
**PCT/EP2009/059894**

(87) Internationale Veröffentlichungsnummer:
**WO 2010/015568 (11.02.2010 Gazette 2010/06)**

(54) **LADEZUSTANDSBESTIMMUNG FÜR EINEN ELEKTRISCHEN SPEICHER**

CHARGE STATUS DETECTION FOR AN ELECTRICAL ACCUMULATOR

DÉTERMINATION DE L'ÉTAT DE CHARGE D'UN ACCUMULATEUR ÉLECTRIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **07.08.2008 DE 102008041103**

(43) Veröffentlichungstag der Anmeldung:
**27.04.2011 Patentblatt 2011/17**

(73) Patentinhaber: **Robert Bosch GmbH**
**70442 Stuttgart (DE)**

(72) Erfinder:
• **BOEHM, Andre**
**70806 Kornwestheim (DE)**
• **LIEDTKE, Ralf**
**70597 Stuttgart (DE)**
• **KERN, Rainer**
**70174 Stuttgart (DE)**

(56) Entgegenhaltungen:
**WO-A-2007/104325　　US-A- 5 578 915**
**US-A1- 2005 212 486**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung betrifft ein Verfahren zur Bestimmung des Ladezustands eines elektrischen Speichers.

Stand der Technik

Beim Einsatz von elektrischen Speichern in Kraftfahrzeugen, insbesondere für elektrische Fahrzeugantriebe, wie beispielsweise bei Hybridfahrzeugen, ist eine genaue Kenntnis des Ladezustands des elektrischen Speichers erforderlich. Sowohl eine Überladung als auch eine Tiefentladung schädigt den elektrischen Speicher und verkürzt dessen Lebensdauer. Für eine Bestimmung des Ladezustands des elektrischen Speichers wird ausgenutzt, dass der elektrische Speicher eine Spannung aufweist, die in Abhängigkeit seiner Beladung variiert. Diese Abhängigkeit ist insbesondere dann genau erfassbar, wenn sich der elektrische Speicher in einem lastfreien Zustand befindet.

In einer ersten bekannten Vorgehensweise ist zur Bestimmung des Ladezustands vorgesehen, die Spannung des elektrischen Speichers zu ermittelt und daraus den Ladezustand zu bestimmen. Ausgehend von dem Ladezustand wird bei einem Lastbetrieb des elektrischen Speichers die dem Speicher entzogene elektrische Energie erfasst und von dem Ladezustands abgezogen. Diese Vorgehensweise zeichnet sich durch eine einfache und effiziente Umsetzung in einem Rechensystem aus, die nur einen geringen Rechenaufwand benötigt. Trotz der Erfassung des Ladezustandes des elektrischen Speichers ist es hierbei möglich, dass eine Speicherzelle überladen oder tiefentladen wird. Dies geschieht dann, wenn der elektrische Speicher aus einer Vielzahl von Speicherzellen besteht und eine Speicherzelle in ihrer Beschaffenheit, beispielsweise durch Alterung, von der Beschaffenheit der anderen Speicherzellen abweicht, da nur der Gesamtzustand des elektrischen Speichers erfasst wird

In einer zweiten bekannten Vorgehensweise werden Spannungen aller Speicherzellen einzeln erfasst und ausgewertet. Ferner wird bei dem Lastbetrieb des Speichers der Ladezustand für jede einzelne Speicherzelle berechnet. Somit ergibt sich für jede Speicherzelle ein eigener Ladezustand. Die Auswertung der Spannungen aller Speicherzellen führt zu einem erheblichen Aufwand bei der Umsetzung, wie beispielsweise zu einem großen Berechnungsaufwand bei einer Umsetzung als Computerprogramm in einem Steuergerät..

Die DE 10 2006 033 629 beschreibt eine Möglichkeit zur Bestimmung des Zustands einer Batterie mittels einer kurzfristigen Belastung der Batterie mit einem Strom in Lade- oder Entladerichtung. Der Zustand wird dabei anhand der Spannungsantwort einzelner Zellen oder Zellgruppen ermittelt. US5578915 offenart ein Verfahren zum Bestimmen des Ladezustands eines elektrischen Speichers. Der Ladezustand des Speichers wird anhand der niedrigsten Einzelzellenspannung ermittelt.

Es wird nunmehr eine Möglichkeit benötigt, den Ladezustand eines elektrischen Speichers vollständig und auf eine einfache Weise zu ermöglichen, die effizient umgesetzt werden kann und bei einer Umsetzung als Computerprogramm nur einen geringen Rechenaufwand benötigt.

Offenbarung der Erfindung

Erfindungsgemäß ist ein Verfahren vorgesehen zum Bestimmen des Ladezustands eines elektrischen Speichers, insbesondere für ein Kraftfahrzeug, mit mehr als zwei Speicherzellen, die jeweils eine elektrische Einzelzellenspannung aufweisen und jeweils die gleiche, den lastfreien Zustand betreffende Kennlinie besitzen, die eine elektrische Beladung der Speicherzelle in Abhängigkeit der Einzelzellenspannung beschreibt, mit den Schritten: Erfassen der Einzelzellenspannungen, Ermitteln der höchsten und/oder der niedrigsten Einzelzellenspannungen und Ermitteln einer vorliegenden Maximalbeladung der zugeordneten Speicherzelle mittels der Kennlinie und der höchsten Einzelzellenspannung und/oder einer vorliegenden Minimalbeladung der zugehörigen Speicherzelle mittels der Kennlinie und der niedrigsten Einzelzellenspannung. Unter "Beladung" wird die gespeicherte Energie, also der elektrische Ladungsinhalt des elektrischen Speichers verstanden. Das Ermitteln der höchsten und/oder der niedrigsten Einzelzellenspannung vor Auswertung der Einzelzellenspannungen spart gegenüber dem Stand der Technik sehr viele Auswertungsschritte ein. Somit ergibt sich eine effiziente Umsetzung des Verfahrens, insbesondere als Computerprogramm, das nur wenig Rechenaufwand benötigt.

Es ist insbesondere dann vorteilhaft das Verfahren anzuwenden, wenn die Kennlinie mindestens bereichsweise monoton, insbesondere streng monoton ist. Der elektrische Speicher ist vorzugsweise als Batterie oder als Akkumulator eines Kraftfahrzeugs ausgebildet. Der Ladezustand wird anhand von ein oder zwei Werten, nämlich der Maximalbeladung und/oder der Minimalbeladung beschrieben. Auf die beschriebene Art und Weise ist es möglich, sämtliche Speicherzellen zu überwachen, wobei eine Auswertung bezüglich des Ladezustands des elektrischen Speichers auf die relevanten Speicherzellen reduziert wird. Die Maximalbeladung gibt dabei die Beladung derjenigen Speicherzelle an, die innerhalb des elektrischen Speichers die höchste Beladung aufweist. Die Minimalbeladung hingegeben bezeichnet die Beladung der Speicherzelle, die innerhalb des elektrischen Speichers die niedrigste Beladung aufweist. Ferner wird im Zuge dieser Anmeldung unter "lastfreiem Zustand" der Zustand des elektrischen Speichers bezeichnet, in dem kein oder nur ein geringer Strom aus dem elektrischen Speicher entnommen, oder in den elektrischen Speicher hineingeführt wird.

Nach einer Weiterbildung der Erfindung ist vorgesehen, dass die Einzelzellenspannungen im lastfreien Zustand erfasst werden. Auf diese Weise wird einem Messfehler vorgebeugt, da die Kennlinie den lastfreien Zustand betrifft und in diesem Fall keinen oder nur einen geringen Fehler bei der Auswertung erzeugt. Durch die Erfassung der Einzelzellenspannungen im lastfreien Zustand aus den Kennlinien ergibt sich somit eine höhere Genauigkeit bei der Bestimmung des Ladezustands.

Nach einer Weiterbildung der Erfindung ist vorgesehen, dass in einem Zeit- und/oder Betriebsintervall des Speichers in jedem neuen lastfreien Zustand die Einzelzellenspannungen erneut erfasst werden und die Maximalbeladung und/oder die Minimalbeladung erneut ermittelt wird/werden. Das erneute Erfassen der Einzelzellenspannungen ermöglicht einen Verlauf der Maximalbeladung und/oder der Minimalbeiadung zu bestimmen. Somit besteht die Möglichkeit, auch einen Verlauf des Ladezustands des elektrischen Speichers zu erfassen und anschließend auszuwerten. Als Zeitintervall können Zeitspannen von Außen vorgegeben oder von einem Steuergerät des Kraftfahrzeugs festgelegt werden. Als Betriebsintervall wird der Zeitraum bezeichnet, in dem der elektrische Speicher in Betrieb genommen ist, was nicht bedeutet, dass ein Strom aus dem elektrischen Speicher entnommen oder zugeführt werden muss.

Nach einer Weiterbildung der Erfindung ist vorgesehen, dass nach dem ersten lastfreien Zustand nur die Einzelzellenspannung/Einzelzellenspannungen der Speicherzelle/Speicherzellen erneut erfasst wird/werden, die im ersten lastfreien Zustand die Minimalbeladung oder/und die Maximalbeladung aufwies/aufwiesen. Auf diese Weise lassen sich zusätzlich weitere Auswertungsschritte des Verfahrens einsparen. Somit ergibt sich eine noch effizientere Umsetzung des Verfahrens als Computerprogramm, das einen noch geringeren Rechenaufwand benötigt. Innerhalb des Zeit- und/oder Betriebsintervalls wird lediglich im ersten lastfreien Zustand bestimmt, welche Speicherzelle die höchst und/oder welche Speicherzelle die niedrigste Einzelzellenspannung aufweist. In allen folgenden lastfreien Zuständen wird nur die mindestens eine Einzelzellenspannung erfasst und ausgewertet, die der Speicherzellen zugeordnet ist, die im ersten lastfreien Zustand bestimmt wurde.

Nach einer Weiterbildung der Erfindung ist vorgesehen, dass in einem Lastzustand des Speichers sein elektrischer Laststrom erfasst wird. Da eine Auswertung der Kennlinie außerhalb des lastfreien Zustands zu einem Fehler des daraus ermittelten Wertes führen kann, ist es besonders vorteilhaft, den elektrischen Laststrom zu erfassen, insbesondere zu messen. Der Laststrom ist der Strom, welcher von dem elektrischen Speicher an einen Verbraucher, wie beispielsweise das Bordnetz des Kraftfahrzeugs, oder an den elektrischen Speicher von einer Stromquelle zum Zwecke des Ladens geführt wird.

Nach einer Weiterbildung der Erfindung ist vorgesehen, dass die aktuelle Maximalbeladung der zugeordneten Speicherzelle im Lastzustand mittels des erfassten Laststroms, dessen bisheriger Zeitdauer und der im letzten lastfreien Zustand erfassten Maximalbeladung der Speicherzelle berechnet wird. Dies ermöglicht, die Maximalbeladung auch dann zu überwachen, wenn der Lastzustand vorliegt. Zu diesem Zweck wird der erfasste Laststrom über dessen Zeitdauer integriert, wobei die Maximalbeladung, welche im letzten lastfreien Zustand erfasst worden ist, dem Ergebnis hinzugefügt wird. Um Folgefehlern vorzubeugen ist es besonders vorteilhaft, den Wert der Maximalbeladung bei jedem lastfreien Zustand erneut aus der Kennlinie zu bestimmen und die Berechnung dann neu zu beginnen.

Nach einer Weiterbildung der Erfindung ist vorgesehen, dass die aktuelle Minimalbeladung der zugeordneten Speicherzelle im Lastzustand mittels des erfassten Laststroms, dessen bisherige Zeitdauer und der im letzten lastfreien Zustand erfassten Minimalbeladung der Speicherzelle berechnet wird. Zu diesem Zweck wird der erfasste Laststrom über dessen Zeitdauer integriert, wobei die Minimalbeladung, welche im letzten lastfreien Zustand erfasst worden ist, dem Ergebnis hinzugefügt wird. Um Folgefehlern vorzubeugen ist es besonders vorteilhaft, den Wert der Minimalbeladung bei jedem lastfreien Zustand erneut aus der Kennlinie zu bestimmen und die Berechnung dann neu zu beginnen.

Nach einer Weiterbildung der Erfindung ist vorgesehen, dass jede Speicherzelle eine obere Beladungsgrenze und/oder eine untere Beladungsgrenze aufweist. Die obere Beladungsgrenze gibt die maximal mögliche Beladung der elektrischen Speicherzelle an. Wird die Speicherzelle, die sich bereits an der oberen Beladungsgrenze befindet weiter geladen, so wird die Speicherzelle überladen. Die untere Beladungsgrenze der Speicherzelle beschreibt die mindestens notwendige Beladung der Speicherzelle. Ein Entladen der Speicherzelle, die sich an der unteren Beladungsgrenze befindet, führt zu einem Tiefentladen. Die Überschreitung der oberen sowie die Unterschreitung der unteren Beladungsgrenze kann zu einer Beschädigung einer oder mehrerer Speicherzellen und somit des elektrischen Speichers führen, weshalb eine Berücksichtigung aller Speicherzellen von großem, insbesondere sicherheitstechnischem Vorteil ist.

Nach einer Weiterbildung der Erfindung ist vorgesehen, dass der Speicher geladen wird, bis die Maximalbeladung der Speicherzelle gleich der oberen Beladungsgrenze ist. Die Verwendung der Maximalbeladung als Referenzpunkt für ein Laden des elektrischen Speichers ermöglicht, den Speicher besonders sicher zu laden, da ein Überladen für sämtliche Speicherzellen verhindert wird, ohne dass sämtliche Speicherzellen ständig auf Ihren Ladezustand hin überwacht werden müssen.

Nach einer Weiterbildung der Erfindung ist vorgesehen, dass der Speicher entladen wird, bis die Minimalbeladung der Speicherzelle gleich der unteren Beladungsgrenze ist. Die Verwendung der Minimalbeladung als Referenzpunkt für ein Laden des elektrischen Speichers ermöglicht, den Speicher besonders sicher zu entladen, da ein Tiefentladen für sämtliche Speicherzellen verhindert wird, ohne dass sämtliche Speicherzellen ständig auf Ihren Ladezustand hin überwacht werden müssen.

Nach einer Weiterbildung der Erfindung ist vorgesehen, dass für einen bestimmten Ladezustand des Speichers eine maximale Leistungsabgabe mittels der Anzahl der Speicherzellen, der niedrigsten Einzelzellenspannung eines vorgegebenen Maximalstroms des Speichers berechnet wird. Dies ist dann vorgesehen, wenn die Speicherzellen innerhalb des elektrischen Speichers in Reihe geschaltet sind. Dann ergibt sich aus der Anzahl der Speicherzellen, der niedrigsten Einzelzellspannung und dem Maximalstrom die maximal verfügbare elektrische Leistung. Der Maximalstrom ergibt sich dabei insbesondere aus konstruktiven Eigenschaften der Batterie, der an der Batterie angeschlossenen Last und/oder möglichen Sicherheitsvorkehrungen wie beispielsweise elektrische Überlastungssicherungen. Ferner ist es denkbar, dass mittels der maximalen Leistungsabgabe und der Minimalbeladung eine minimale Betriebszeit im Lastzustand und/oder mittels der maximalen Leistungsabgabe und der Maximalbeladung eine maximale Betriebszeit im Lastzustand errechnet wird

Nach einer Weiterbildung der Erfindung ist vorgesehen, dass für einen bestimmten Ladezustand des Speichers seine maximale Leistungsabgabe mittels der niedrigsten Einzelzellenspannung und eines vorgegebenen Maximalstroms des Speichers berechnet wird. Dies ist dann vorgesehen, wenn die Speicherzellen innerhalb des elektrischen Speichers parallel zueinander geschaltet sind. In diesem Fall ergibt sich die maximale Leistungsabgabe aus dem Produkt der niedrigsten Einzelzellenspannung und des vorgegebenen Maximalstroms. Auch hier besteht die Möglichkeit, die minimale und die maximale Betriebszeit des elektrischen Speichers zu errechnen, wie dies bereits beschrieben worden ist.

Ferner betrifft die Erfindung eine Erfassungsvorrichtung zum Bestimmen des Ladezustands eines elektrischen Speichers, vorzugsweise für ein Kraftfahrzeug, insbesondere zur Durchführung eines der vorangegangen beschriebenen Verfahren, wobei der Speicher mehr als zwei Speicherzellen besitzt, die jeweils eine elektrische Einzelzellenspannung aufweisen und jeweils die gleiche, den lastfreien Zustand betreffende Kennlinie besitzen, die in eine elektrische Beladung der Speicherzelle in Abhängigkeit der Einzelzellenspannung beschreibt, mit einer Einzelzellenspannungserfassungsvorrichtung, mit einer Vergleichseinrichtung für eine Ermittlung der höchsten und/oder der niedrigsten Einzelzellenspannung, mit einem Datenspeicher, in dem die Kennlinie gespeichert ist, und einer Berechnungseinheit zum Ermitteln einer vorliegenden Maximalbeladung der zugeordneten Speicherzelle mittels der Kennlinie und der höchsten Einzelzellenspannung und/oder einer vorliegenden Minimalbeladung der zugehörigen Speicherzelle mittels der Kennlinie und der niedrigsten Einzelzellenspannung.

In einer Weiterbildung der Erfassungsvorrichtung ist eine Stromerfassungsvorrichtungen für einen Lastzustand des Speichers vorgesehen. Die Stromerfassungsvorrichtung erfasst - insbesondere misst - den Laststrom, welcher in den Speicher geführt oder aus dem Speicher entnommen wird.

Nach einer Weiterbildung der Erfassungsvorrichtung ist eine Beladungsberechnungseinheit für den Lastzustand vorgesehen. Diese berechnet anhand des, vorzugsweise von der Stromerfassungsvorrichtung, erfassten Laststroms und der letzten erfassten Maximalbeladung und/oder der Minimalbeladung den aktuellen Ladezustand des elektrischen Speichers in Form der aktuellen Maximalbeladung und/oder der aktuellen Minimalbeladung.

Nach einer Weiterbildung der Erfassungsvorrichtung ist vorgesehen, dass es als Steuergerät, insbesondere für ein Kraftfahrzeug, ausgebildet ist. Es ist denkbar, dass das Steuergerät zusätzliche Funktionen für das Kraftfahrzeug übernimmt. Ferner kann die Erfassungsvorrichtung eines Batteriemanagementsystems des Kraftfahrzeugs zugeordnet sein.

Kurze Beschreibung der Zeichnungen

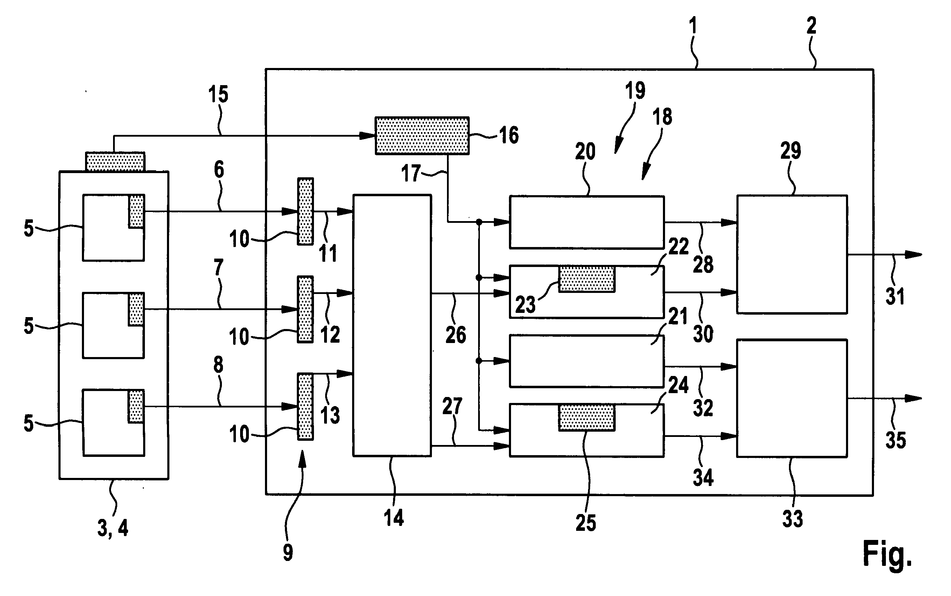

Die Figur verdeutlicht das erfindungsgemäße Verfahren anhand einer schematischen Darstellung einer Erfassungsvorrichtung.

Ausführungsform(en) der Erfindung

Die Figur zeigt eine schematische Darstellung einer Erfassungsvorrichtung 1 in Form eines Steuergeräts 2 eines nicht dargestellten Kraftfahrzeugs. Die Erfassungsvorrichtung 1 bestimmt den Ladezustand eines elektrischen Speichers 3, welcher als Kraftfahrzeugbatterie 4 ausgebildet ist. Der elektrische Speicher 3 weist Speicherzellen 5 auf, die jede für sich eine eigene Einzelzellenspannung aufweist, also die elektrische Spannung an einer einzelnen Speicherzelle 5. Ferner besitzt jede Speicherzelle 5 eine eigene elektrische Beladung. Befinden sich die Speicherzellen 5 in einem lastfreien Zustand, das heißt dass sie nur wenig oder gar keinen elektrischen Strom abgeben, ist ihre Einzelzellenspannung ein sehr gutes Maß für ihre elektrische Beladung. Die Beziehung zwischen der Einzelzellenspannung und der elektrischen Beladung wird über eine Kennlinie beschrieben. Die Einzelzellenspannungen der Speicherzellen 5 werden über Pfeile 6, 7 und 8 an eine Einzelspannungserfassungsvorrichtung 9, welche aus mehreren Erfassungskomponenten 10 besteht, weitergegeben. Die Erfassungskomponenten 10 stehen jeweils über einen Pfeil 11, 12 oder 13 mit einer Vergleichseinrichtung 14 in Verbindung. Die Vergleichseinrichtung 14 erhält somit über die Pfeile 11, 12 und 13 die erfassten Einzelspannungen der Speicherzellen 5. Über einen Pfeil 15 wird einer Stromerfassungsvorrichtung 16 der Laststrom zugeführt. Der von der Stromerfassungsvorrichtung 16 erfasste Laststrom wird über den Mehrfachpfeil 17 sowohl an eine Beladungsberechnungseinheit 18 und eine Berechnungseinheit 19 weitergegeben. Die Beladungsberechnungseinheit 18 besteht aus einem ersten Integrator 20 und einen zweiten Integrator 21. Die Berechnungseinheit 19 besteht aus einem ersten Minimalbeladungsrechner 22, welcher einen Datenspeicher 23 für eine Kennlinie besitzt, und aus einem Maximalbeladungsrechner 24, der einen Datenspeicher 25 für eine Kennlinie besitzt. Dem Minimalbeladungsrechner 22 wird zusätzlich die niedrigste Einzelzellenspannung des elektrischen Speichers 3 über einen Pfeil 26 zugeführt. Dem Maximalbeladungsrechner 24 wird zusätzlich die höchste Einzelzellenspannung des elektrischen Speichers 3 von der Vergleichseinrichtung 14 über den Pfeil 27 zugeführt. Der Integrator 20 übergibt eine erste potentielle Minimalbeladung, die für den Lastzustand, über einen Pfeil 28 an eine erste Unterscheidungseinrichtung 29. Der Minimalbeladungsrechner 22 übergibt eine zweite potentielle Minimalbeladung, die für den lastfreien Zustand, an die Unterscheidungseinrichtung 29 über den Pfeil 30 weiter. Die Unterscheidungseinrichtung 29 gibt abschließend über einen Pfeil 31 eine Minimalbeladung aus. Der Integrator 21 übergibt mittels des Pfeils 32 eine erste potentielle Maximalbeladung, die für den Lastzustand, an eine zweite Unterscheidungseinrichtung 33. Der Maximalbeladungsrechner 24 übergibt ferner mittels des Pfeils 34 eine zweite potentielle Maximalbeladung, die für den lastfreien Zustand. Die zweite Unterscheidungseinrichtung 33 gibt abschließend über einen Pfeil 35 die Maximalbeladung aus.

Jede Speicherzelle 5 des elektrischen Speichers 3 weist eine obere und eine untere Beladungsgrenze auf. Wird die Speicherzelle 3 über die obere Beladungsgrenze hinaus geladen, so liegt eine Überladung vor, wodurch die Speicherzelle 5 Schaden nehmen kann. Wird die Speicherzelle 5 unter die untere Beladungsgrenze entladen, so liegt eine Tiefentladung an der Speicherzelle 5 vor, wodurch diese ebenfalls Schaden nehmen kann. Die Bestimmung des Ladezustands des elektrischen Speichers 3 ermöglicht es, bei einem Laden des elektrischen Speichers 3 die obere Beladungsgrenze sowie die untere Beladungsgrenze zu berücksichtigen. Besitzen die Speicherzellen 5 jeweils eine eigene obere und/oder untere Beladungsgrenze, so ist es vorteilhaft, wenn der Ladezustand des elektrischen Speichers 3 anhand der elektrischen Beladung jeder einzelnen Speicherzelle 5 erfasst wird. Derartige Unterschiede in den Beladungsgrenzen können beispielsweise durch Alterungseffekte des elektrischen Speichers 3 hervorgerufen werden. Die Einzelspannungserfassungsvorrichtung 9 erfasst die Einzelzellenspannung der Speicherzellen 5 und gibt diese Einzelzellenspannung an die Vergleichseinrichtung 14 weiter. Die Vergleichseinrichtung 14 vergleicht sämtliche erhaltenen Einzelzellenspannungen und gibt die höchste Einzelzellenspannung über den Pfeil 27 und die niedrigste Einzelzellenspannung über den Pfeil 26 aus. Sowohl im Minimalbeladungsrechner 22 als auch im Maximalbeladungsrechner 24 wird anhand der erhaltenen Einzelzellenspannung und der in den Datenspeichern 23 und 25 enthaltenen Kennlinien entsprechend die zweite potentielle Minimalbeladung oder die zweite potentielle Maximalbeladung für den lastfreien Zustand ermittelt. Die Kennlinie wurde im Vorfeld, beispielsweise durch Versuchsreihen, bestimmt. Ferner ist es denkbar, die Kennlinie temperaturabhängig zu gestalten und die Datenspeicher 23 und 25 beispielsweise zusätzlich mit einer Temperaturerfassungsvorrichtung, welche hier nicht dargestellt ist, zu verbinden. In den Integratoren 20 und 21 wird anhand des erfassten Laststroms die aus den Speicherzellen 5 entnommene elektrische Beladung durch Integration berechnet. Der im Integrator 20 ermittelte Wert kann mit einer bereits von dem Minimalbeladungsrechner 22 ermittelten zweiten potentiellen Minimalbeladung, welche zum Zeitpunkt des Beginns der Integration ermittelt wurde, addiert werden. Somit dient die zweite potentielle Minimalbeladung, die des lastfreien Zustands, als Anfangswert für diese Berechnung. Der Integrator 20 übergibt dann die so errechnete erste potentielle Minimalbeladung, die für den Lastzustand, über den Pfeil 28 an die erste Unterscheidungseinrichtung 29. Die Unterscheidungseinrichtung 29 prüft, ob aktuell an dem elektrischen Speicher 3 der lastfreie Zustand oder der Lastzustand vorliegt. Liegt der lastfreie Zustand vor, so wird die zweite potentielle Minimalbeladung als Minimalbeladung über den Pfeil 31 ausgegeben. Liegt der Lastzustand vor, so wird die erste potentielle Minimalbeladung über den Pfeil 31 ausgegeben. In entsprechender Weise arbeitet der zweite Integrator 21 mit dem Maximalbeladungsrechner 24 und der zweiten Unterscheidungseinrichtung 33 zusammen. Diese gibt dann die Maximalbeladung über den Pfeil 35 aus.

Die auf diese Weise erhaltenen Minimal- und die Maximalbeladung ermöglichen es, den elektrischen Speicher 3 auf sichere Weise zu be- und entladen. Es ist gewährleistet, dass keine der Speicherzellen 5 überladen oder tiefentladen wird. Die Erfassung des Ladezustands des elektrischen Speichers 3 zeichnet sich insbesondere dadurch aus, dass nur eine geringe Anzahl an Auswerteschritten durchgeführt werden muss und gleichzeitig sämtliche Speicherzellen 5 überwacht werden.

Innerhalb eines bestimmten Zeit- oder Betriebsintervalls, welches programmiertechnisch vorgegeben oder von anderen Steuergeräten oder Ereignissen bestimmt sein kann, ergibt sich die Möglichkeit, die Anzahl der Auswerteschritte weiter zu verkleinern, indem innerhalb des Zeit- und/oder Betriebsintervalls nur ein einziges Mal sämtliche Einzelzellenspannungen erfasst werden. Nach der ersten Auswertung der Vergleichseinrichtung 14 werden in allen folgenden lastfreien Zuständen nur die zwei Speicherzellen 5 von der Einzelspannungserfassungsvorrichtung erfasst, die im ersten lastfreien Zustand die höchste und die niedrigste Einzelzellenspannung aufgewiesen haben.

Ferner können die Minimal- und die Maximalbeladung für eine Ermittlung der maximalen Leistungsabgabe des elektrischen Speichers 3 verwendet werden. Für die maximale Leistungsabgabe bei dem elektrischen Speicher kann die folgende Formel verwendet werden, sofern die Speicherzellen 5 in Reihe zueinander geschaltet sind:

$$P_{Batterie,Entladung} = n \cdot U_{min} \cdot I.$$

Die maximale Leistungsabgabe $P_{Batterie,Entladung}$ ergibt sich somit aus einer Anzahl n der Speicherzellen 5 multipliziert mit der niedrigsten Einzelzellenspannung $U_{min}$ und einem vorgegebenen Maximalstrom I.

Sind die Speicherzellen 5 parallel zueinander geschaltet, so lässt sich die Maximalleistungsabgabe $P_{Batterie,Entladung}$ wie folgt berechnen:

$$P_{Batterie,Entladung} = U_{min} \cdot I$$

In entsprechender Weise lässt sich auch die maximale Leistungsaufnahme unter Verwendung der höchsten Einzelzellenspannung und eines maximalen Ladestroms berechnen.

**Patentansprüche**

1. Verfahren zum Bestimmen des Ladezustands eines elektrischen Speichers (3), insbesondere für ein Kraftfahrzeug, mit mehr als zwei Speicherzellen (5), die jeweils eine elektrische Einzelzellenspannung aufweisen und jeweils die gleiche, den lastfreien Zustand betreffende Kennlinie besitzen, die eine elektrische Beladung der Speicherzelle (5) in Abhängigkeit der Einzelzellenspannung beschreibt, mit den Schritten:

   - Erfassen der Einzelzellenspannungen,
   - Ermitteln der höchsten und/oder der niedrigsten Einzelzellenspannung **dadurch gekennzeichnet, dass**
   - eine vorliegende Maximalbeladung der zugeordneten Speicherzelle (5) mittels der Kennlinie und der höchsten Einzelzellenspannung und/oder eine orliegende Miminalbeladung der zugehörigen Speicherzelle (5) mittels der Kennlinie und der niedrigsten Einzelzellenspannung ermittelt werden.

2. Verfahren nach Anspruch 1, **dadurch gekennzeichnet, dass** die Einzelzellenspannungen im lastfreien Zustand erfasst werden.

3. Verfahren nach einem der vorhergehenden Ansprüche, **dadurch gekennzeichnet, dass** in einem Zeit- und/oder Betriebsintervall des Speichers (3) in jedem neuen lastfreien Zustand die Einzelzellenspannungen erneut erfasst werden und die Maximalbeladung und/oder die Minimalbeladung erneut ermittelt wird/werden.

4. Verfahren nach einem der vorhergehenden Ansprüche, **dadurch gekennzeichnet, dass** nach dem ersten lastfreien Zustand nur die Einzelzellenspannung/Einzelzellenspannungen der Speicherzelle/Speicherzellen (5) erneut erfasst wird/werden, die im ersten lastfreien Zustand die Minimalbeladung oder/und die Maximalbeladung aufwies/aufwiesen.

5. Verfahren nach einem der vorhergehenden Ansprüche, **dadurch gekennzeichnet, dass** ein einem Lastzustand des Speichers (3) sein elektrischer Laststrom erfasst wird.

6. Verfahren nach einem der vorhergehenden Ansprüche, **dadurch gekennzeichnet, dass** die aktuelle Maximalbeladung der zugeordneten Speicherzelle (5) im Lastzustand mittels des erfassten Laststroms, dessen bisheriger Zeitdauer und der im letzten lastfreien Zustand erfassten Maximalbeladung der Speicherzelle (5) berechnet wird.

7. Verfahren nach einem der vorhergehenden Ansprüche, **dadurch gekennzeichnet, dass** die aktuelle Minimalbeladung der zugeordneten Speicherzelle (5) im Lastzustand mittels des erfassten Laststroms, dessen bisherige Zeitdauer und der im letzten lastfreien Zustand erfassten Minimalbeladung der Speicherzelle (5) berechnet wird.

8. Verfahren nach einem der vorhergehenden Ansprüche, **dadurch gekennzeichnet, dass** jede Speicherzelle (5) eine obere Beladungsgrenze und/oder eine untere Beladungsgrenze aufweist.

9. Verfahren nach einem der vorhergehenden Ansprüche, **dadurch gekennzeichnet, dass** der Speicher (3) geladen wird, bis die Maximalbeladung der Speicherzelle (5) gleich der oberen Beladungsgrenze ist.

10. Verfahren nach einem der vorhergehenden Ansprüche, **dadurch gekennzeichnet, dass** der Speicher (3) entladen wird, bis die Minimalbeladung der Speicherzelle (5) gleich der unteren Beladungsgrenze ist.

11. Verfahren nach einem der vorhergehenden Ansprüche, **dadurch gekennzeichnet, dass** für einen bestimmten Ladezustand des Speichers (3) seine maximale Leistungsabgabe mittels der Anzahl der Speicherzellen (5), der niedrigsten Einzelzellenspannung und eines vorgegebenen Maximalstroms des Speichers (3) berechnet wird.

**EP 2 313 287 B1**

**12.** Verfahren nach einem der vorhergehenden Ansprüche, **dadurch gekennzeichnet, dass** für einen bestimmten Ladezustand des Speichers (3) seine maximale Leistungsabgabe mittels der niedrigsten Einzelzellenspannung und eines vorgegebenen Maximalstroms des Speichers (3) berechnet wird.

**13.** Erfassungsvorrichtung (1) zum Bestimmen des Ladezustands eines elektrischen Speichers (3), vorzugsweise für ein Kraftfahrzeug, insbesondere zur Durchführung eines Verfahrens nach einem oder mehreren der vorhergehenden Ansprüche, wobei der Speicher (3) mehr als zwei Speicherzellen (5) besitzt, die jeweils eine elektrische Einzelzellenspannung aufweisen und jeweils die gleiche, den lastfreien Zustand betreffende Kennlinie besitzen, die eine elektrische Beladung der Speicherzelle (5) in Abhängigkeit der Einzelzellenspannung beschreibt, mit einer Einzelspannungserfassungsvorrichtung, mit einer Vergleichseinrichtung für eine Ermittlung der höchsten und/oder der niedrigsten Einzelzellenspannung, mit einem Datenspeicher (23), in dem die Kennlinie gespeichert ist **gekennzeichnet durch** Berechnungs-einheit (19) zum Ermitteln einer vorliegenden Maximalbeladung der zugeordneten Speicherzelle (5) mittels der Kennlinie und der höchsten Einzelzellenspannung und/oder einer vorliegenden Minimalbeladung der zugehörigen Speicherzelle (5) mittels der Kennlinie und der niedrigsten Einzelzellenspannung.

**14.** Erfassungsvorrichtung (1) nach Anspruch 12, **gekennzeichnet durch** eine Stromerfassungsvorrichtung für einen Lastzustand des Speichers (3).

**15.** Erfassungsvorrichtung (1) nach einem der vorhergehenden Ansprüche, **gekennzeichnet durch** eine Beladungsberechnungseinheit (18) für den Lastzustand.

**16.** Erfassungsvorrichtung (1) nach einem der vorhergehenden Ansprüche, **dadurch gekennzeichnet, dass** es als Steuergerät (2), insbesondere für ein Kraftfahrzeug, ausgebildet ist.

**Claims**

**1.** Method for determining the state of charge of an electrical storage means (3), in particular for a motor vehicle, having more than two storage cells (5) which each have an individual electrical cell voltage and each have the same characteristic curve relating to the load-free state, which characteristic curve describes an electrical charge of the storage cell (5) as a function of the individual cell voltage, comprising the steps of:

- detecting the individual cell voltages,
- ascertaining the highest and/or the lowest individual cell voltage, **characterized in that**
- an existing maximum charge of the associated storage cell (5) is ascertained by means of the characteristic curve and the highest individual cell voltage and/or an existing minimum charge of the associated storage cell (5) is ascertained by means of the characteristic curve and the lowest individual cell voltage.

**2.** Method according to Claim 1, **characterized in that** the individual cell voltages are detected in the load-free state.

**3.** Method according to either of the preceding claims, **characterized in that** the individual cell voltages are detected again in a time and/or operating interval of the storage means (3) in each new load-free state, and the maximum charge and/or the minimum charge are/is ascertained again.

**4.** Method according to one of the preceding claims, **characterized in that**, after the first load-free state, only the individual cell voltage/individual cell voltages of the storage cell/storage cells (5) which exhibited the minimum charge or/and the maximum charge in the first load-free state is/are detected again.

**5.** Method according to one of the preceding claims, **characterized in that** the electrical load current of the storage means (3) is detected in a load state of the said storage means.

**6.** Method according to one of the preceding claims, **characterized in that** the current maximum charge of the associated storage cell (5) in the load state is calculated by means of the detected load current, the previous duration of the said load current and the maximum charge of the storage cell (5) which was detected in the last load-free state.

**7.** Method according to one of the preceding claims, **characterized in that** the current minimum charge of the associated storage cell (5) in the load state is calculated by means of the detected load current, the previous duration of the said load current and the minimum charge of the storage cell (5) which was detected in the last load-free state.

**8.** Method according to one of the preceding claims, **characterized in that** each storage cell (5) has an upper charge limit and/or a lower charge limit.

**9.** Method according to one of the preceding claims, **characterized in that** the storage means (3) is charged until the maximum charge of the storage

7

cell (5) is equal to the upper charge limit.

10. Method according to one of the preceding claims, **characterized in that** the storage means (3) is discharged until the minimum charge of the storage cell (5) is equal to the lower charge limit.

11. Method according to one of the preceding claims, **characterized in that** the maximum power output of the storage means (3) for a specific state of charge of the said storage means is calculated by means of the number of storage cells (5), the lowest individual cell voltage and a predefined maximum current of the storage means (3).

12. Method according to one of the preceding claims, **characterized in that** the maximum power output of the storage means (3) for a specific state of charge of the said storage means is calculated by means of the lowest individual cell voltage and a predefined maximum current of the storage means (3).

13. Detection apparatus (1) for determining the state of charge of an electrical storage means (3), preferably for a motor vehicle, in particular for carrying out a method according to one or more of the preceding claims, with the storage means (3) having more than two storage cells (5) which each have an individual electrical cell voltage and each have the same characteristic curve relating to the load-free state, which characteristic curve describes an electrical charge of the storage cell (5) as a function of the individual cell voltage, having an individual voltage detection apparatus, having a comparison device for ascertaining the highest and/or the lowest individual cell voltage, having a data storage means (23) in which the characteristic curve is stored, **characterized by** a calculation unit (19) for ascertaining an existing maximum charge of the associated storage cell (5) by means of the characteristic curve and the highest individual cell voltage and/or ascertaining an existing minimum charge of the associated storage cell (5) by means of the characteristic curve and the lowest individual cell voltage.

14. Detection apparatus (1) according to Claim 12, **characterized by** a current detection apparatus for a load state of the storage means (3).

15. Detection apparatus (1) according to one of the preceding claims, **characterized by** a charge calculation unit (18) for the load state.

16. Detection apparatus (1) according to one of the preceding claims, **characterized in that** it is in the form of a controller (2), in particular for a motor vehicle.

**Revendications**

1. Procédé de détermination de l'état de charge d'un accumulateur électrique (3), en particulier pour véhicules automobiles, avec plus de deux cellules d'accumulateur (5) qui présentent chacune une tension électrique individuelle de cellule et qui possèdent chacune la même ligne caractéristique qui décrit la charge électrique de la cellule d'accumulateur (5) en fonction de la tension de la cellule individuelle lorsque aucun consommateur n'y est raccordé,
le procédé comportant les étapes qui consistent à :

saisir les tensions des différentes cellules,
déterminer la tension de cellule la plus élevée et/ou la tension de cellule la plus basse,

**caractérisé en ce que**
la cellule d'accumulateur (5) qui présente la charge maximale est déterminée au moyen de la ligne caractéristique comme étant celle dont la tension de cellule est la plus haute et/ou la cellule d'accumulateur (5) qui présente la charge minimale est déterminée au moyen de la ligne caractéristique comme étant celle dont la tension de cellule est la plus basse.

2. Procédé selon la revendication 1, **caractérisé en ce que** la tension des différentes cellules est saisie lorsque aucun consommateur n'y est raccordé.

3. Procédé selon l'une des revendications précédentes, **caractérisé en ce que** dans un intervalle de temps et/ou d'utilisation de l'accumulateur (3), la tension des différentes cellules est saisie à nouveau et la charge maximale et/ou la charge minimale sont déterminées à nouveau chaque fois qu'aucun consommateur n'y est raccordé.

4. Procédé selon l'une des revendications précédentes, **caractérisé en ce qu'**après la première fois où aucun consommateur n'est raccordé à la ou aux cellules d'accumulateur (5), seule la tension de la ou des cellules qui présentaient la charge minimale et/ou la charge maximale la première fois où aucun consommateur n'y était raccordé sont saisies de nouveau.

5. Procédé selon l'une des revendications précédentes, **caractérisé en ce que** le courant électrique délivré par l'accumulateur (3) lorsque l'accumulateur est raccordé à un consommateur est saisi.

6. Procédé selon l'une des revendications précédentes, **caractérisé en ce que** la cellule d'accumulateur (5) dont la charge est effectivement maximale est déterminée par calcul au moyen du courant délivré saisi lorsque la cellule d'accumulateur est raccordée à un consommateur et de la durée pendant laquelle ce courant a été délivré comme étant la cellule d'accumulateur (5) qui présentait la charge maximale la dernière fois où la cellule n'était pas raccordée à un consommateur.

7. Procédé selon l'une des revendications précédentes, **caractérisé en ce que** la cellule d'accumulateur (5) dont la charge est effectivement minimale est déterminée par calcul au moyen du courant délivré saisi lorsque la cellule d'accumulateur est raccordée à un consommateur et de la durée pendant laquelle ce courant a été délivré comme étant la cellule d'accumulateur (5) qui présentait la charge minimale la dernière fois où la cellule n'était pas raccordée à un consommateur.

8. Procédé selon l'une des revendications précédentes, **caractérisé en ce que** chaque cellule d'accumulateur (5) présente une limite supérieure de sa charge et/ou une limite inférieure de sa charge.

9. Procédé selon l'une des revendications précédentes, **caractérisé en ce que** l'accumulateur (3) est chargé jusqu'à ce que la charge maximale de la cellule d'accumulateur (5) soit égale à la limite supérieure de la charge.

10. Procédé selon l'une des revendications précédentes, **caractérisé en ce que** l'accumulateur (3) est déchargé jusqu'à ce que la charge minimale de la cellule d'accumulateur (5) soit égale à la limite inférieure de la charge.

11. Procédé selon l'une des revendications précédentes, **caractérisé en ce que** pour un état de charge défini de l'accumulateur (3), sa puissance délivrée maximale est calculée au moyen du nombre de cellules d'accumulateur (5), de la plus basse tension de cellule et du courant maximum prédéterminé que délivre l'accumulateur (3).

12. Procédé selon l'une des revendications précédentes, **caractérisé en ce que** pour un état de charge défini de l'accumulateur (3), sa puissance délivrée maximale est calculée au moyen de la plus petite tension de cellule et du courant maximum prédéterminé que délivre l'accumulateur (3).

13. Dispositif de saisie (1) servant à déterminer l'état de charge d'un accumulateur électrique (3), de préférence pour véhicules automobiles, en particulier en vue de la mise en oeuvre d'un procédé selon l'une ou plusieurs des revendications précédentes, dans lequel l'accumulateur (3) comporte

   plus de deux cellules d'accumulateur (5) qui présentent chacune une tension de cellule et la même ligne caractéristique qui décrit la charge électrique de la cellule d'accumulateur (5) en fonction de la tension de la cellule lorsqu'aucun consommateur n'y est raccordé,

   un dispositif de saisie des différentes tensions, un dispositif de comparaison qui détermine la plus haute et/ou la plus basse tension de cellule,

   une mémoire de données (23) dans laquelle la ligne caractéristique est conservée en mémoire, **caractérisé par**

   une unité de calcul (19) qui détermine au moyen de la ligne caractéristique la cellule d'accumulateur (5) qui présente la charge maximale comme étant celle dont la tension de cellule est la plus haute et/ou qui détermine au moyen de la ligne caractéristique la cellule d'accumulateur (5) qui présente la charge minimale comme étant celle dont la tension de cellule est la plus basse.

14. Dispositif de saisie (1) selon la revendication 12, **caractérisé par** un dispositif qui saisit le courant délivré lorsque l'accumulateur (3) est raccordé à un consommateur.

15. Dispositif de saisie (1) selon l'une des revendications précédentes, **caractérisé par** une unité (18) qui calcule la charge lorsque l'accumulateur est raccordé à un consommateur.

16. Dispositif de saisie (1) selon l'une des revendications précédentes, **caractérisé en ce qu'**il est configuré comme appareil de commande (2), en particulier pour véhicules automobiles.

EP 2 313 287 B1

Fig.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006033629
- US 5578915 A